Europäisches Patentamt

European Patent Office

Office européen des brevets

(11) Publication number: **0 091 625**
**B1**

## EUROPEAN PATENT SPECIFICATION

(45) Date of publication of patent specification: **30.07.86**

(51) Int. Cl.⁴: **C 09 K 11/00, F 21 K 2/00**

(21) Application number: **83103257.8**

(22) Date of filing: **05.04.83**

(54) **Method of storing and conveying radiated energy by means of luminescent materials.**

(30) Priority: **13.04.82 US 367859**

(43) Date of publication of application:
**19.10.83 Bulletin 83/42**

(45) Publication of the grant of the patent:
**30.07.86 Bulletin 86/31**

(84) Designated Contracting States:
**BE DE FR GB IT NL**

(56) References cited:
**GB-A-2 063 904**
**US-A-3 291 749**

(73) Proprietor: **ALTERNATIVE ENERGY RESEARCH CENTER INC.**
**Edificio Comosa Avenues Samuel Lewis and Manuel M. Ycaza Case Postale 4150**
**Panama (PA)**

(72) Inventor: **Kabay, Ernest**
**Via Castegnini 21**
**I-36050 Sovizzo(Vicenza) (IT)**
Inventor: **Kabay, Gabriella née Hamvas**
**Via Castegnini 21**
**I-36050 Sovizzo(Vicenza) (IT)**

(74) Representative: **Modiano, Guido et al**
**MODIANO, JOSIF, PISANTY & STAUB Modiano & Associati Via Meravigli, 16**
**I-20123 Milan (IT)**

## Description

The present invention relates to a method of storing and conveying energy by means of luminescent materials.

As is known, some luminescent materials have the property of absorbing and storing light energy upon excitation by suitable radiation and of emitting the said stored energy in the form of light energy upon being stimulated by suitable stimulation radiation.

More particularly, the following terminology is used below in connection with luminescent materials;

excitation energy, i.e. corpuscolar or undulatory radiated energy (light, α rays, UV radiation, etc.);

excitation refers to the raising of an electron associated with an atom, or a group of atoms, to a higher energy state;

storage centers, i.e. electron traps which can capture an excited electron produced in the luminescent material and prevents the electron from falling to a normallly filled level. The said traps are considered as a form of potential well.

Phosphorescence means delayed emission by the excited electron traps.

Fluorescence means emission immediately following excitation, or emission following with a delay shorter than $10^{-8}$ seconds.

Stimulation and stimulated emission indicate the intensity of the emitted light or its rate of decay increased or accelerated by applying energy or non-exciting radiation. This process which is termed stimulation always follows excitation and produces stimulated emission.

Quenching indicates decrease in luminescent intensity during irradiation by non-exciting energy. This phenomenon is the opposite of stimulation.

Stimulability is the stimulating energy to stimulated emission ratio.

Exhaustion is the decrease of stimulated emission during continuous stimulation.

Circulating medium is the medium in which luminescent particles or energy storage centers are suspended, thereby making it possible for the energy storage centers to flow.

Energy absorption indicates the phenomenon by which fully or partly exhausted energy storgae centers are recharged by excitation.

Energy conveyance is achieved by causing the circulating medium to flow in a circuit, wherein the circulating medium carries charged storage centers.

Stored energy is the energy released by the trapped electons during their return travel from the trap to their normally occupied level (ground state). In technical terms this is called "light sum" and means total emission upon stimulation.

To clarify the background on which the method according to the present invention is based, phenomena connected with energy absorption and release by luminescent materials are further described.

An exhausted phosphor has the property of absorbing energy from an excitation source in a given frequency spectrum termed absorption spectrum.

The phosphor can respond in four different ways, to excitation radiation.

A first possible response of the phosphor to excitation is reflexion which of course occurs in the same spectrum as that of the excitation rediation and its intensity is approximately constant.

A second possibility is given by transmission owing to which the excitation radiation passes through the material. The percentage of radiation transmitted is usually rather small and depends on the thickness of the sample.

A third possibility of transferring energy is fluorescence in which a phosphor immediately reradiates the energy it has absorbed. Fluorescence emission occurs in a spectrum comprising a wavelength longer than that of the excitation radiation.

The intensity of fluorescent emission is at a low value at the beginning for an exhausted phosphor, rapidly increases in time and tends to reach a constant value.

A fourth possibility is to absorb radiating energy and to store it in the electron traps. An exhausted phosphor initially absorbs a large amount of energy upon being excited but its absorption rate decreases in time while the phosphor reaches its fully excited state.

The fully excited state is reached when the material neither accepts nor absorbs further energy to be stored. If excitation is ceased, phosphorescence of the luminescent material occurs. The initial intensity of phosphorescence is smaller than the fluorescence intensity and decays at a rate such that it is no longer distinguishable with the naked eye after a few seconds. A charged phosphor can keep the energy it has absorbed for several days or weeks without experiencing considerable losses.

US—A—3 291 749 disclosed a photoluminescent composition and teaches to remit at once the absorbed light, without any storage.

GB—A—2 063 904 disclosed a process of storing and subsequently releasing light energy, in which the light is stored on a strip of semiconductor material.

From the above it is of high interest to investigate the possibility of conveying light energy from a source zone to a different zone where it is used by taking advantage of the characteristic features of the luminescent materials.

An object of the present invention is to provide a method which makes it possible to convey light or other type of radiated energy (α rays, UV radiation, etc.) so as to obtain light energy in a selectable spectrum range in times and in places where it is to be used.

In this context, a particular object of the present invention is to provide a method for storing and conveying light or other type of radiated energy, which method is sufficiently efficient and makes it possible to vary the energy absorption efficiency and the emission rate of the absorbed energy.

Another object of the present invention is to provide a method of storing and conveying light or other type of radiated energy, by making use of materials which can be employed several times in successive cycles as storing means.

A further object of the present invention is to provide a method for storing and conveying light or other type of radiated energy, which makes it possible to vary the basic luminescent parameters of the materials used as energy storing means compared to the parameters of the same stationary fluid or solid materials.

These and further objects which will better appear below, are attained by a method of absorbing, conveying, storing and reemitting radiated energy. It comprises the step of energy absorption, where the suspended luminescent material is conveyed through an area exposed to the radiated energy, and the absorption efficiency is controlled by the conveying velocity of the luminescent fluid. The charged luminescent media is then stored and conveyed to another zone exposed to stimulating radiation, releasing the stored energy in the form of stimulated emission. The rate of energy release is controlled by the intensity of the stimulation and conveying velocity. Following this step, the discharged luminescent fluid is conveyed back to the energy absorption section for further continuous operation.

Phosphors that can be used for carrying out the method in accordance with the present invention must possess specific characteristic features in so far as absorption spectrum and spectral distribution of stimulated emission are concerned. A number of suitable phosphors are indicated in the following Table 1.

TABLE 1

Peak wavelength in NM

| No. | Phosphors | Absorption | Emission | Stimulation |
|---|---|---|---|---|
| 1 | $Sr(S:Se):F:Sm:Eu$ | 460 | 570 | 930 |
| 2 | $SrS:F:Sm:Eu$ | 480 | 630 | 1020 |
| 3 | $Ca(S:Se):F:Sm:Eu$ | 480 | 630 | 1100 |
| 4 | $CaS:F:Sm:Eu$ | 480 | 660 | 1170 |
| 5 | $SrS:F:Sm:Ce$ | α rays   290<br>350 | 480<br>540 | 1020<br>1020 |
| 6 | $ZnS:Cu:NaCl:PbSO_4$ | 370 | 488 | 750<br>1320 |
| 7 | $SrS:F:Cu:Sm$ | 280 | 480 | 1050 |
| 8 | $SrS:F:Ce:Sn$ | 350 | 580 | 1040 |
| 9 | $SrS:F:Cu:Bi$ | 450 | 630 | 1050 |
| 10 | $ZnS:F:PbSO_4:Cu:CdS$ | UV | yellow | 1300 |
| 11 | $ZnS:F:PbSO_4:Mn:Cu$ | UV | orange | 1300 |

As to the absorption spectrum the following considerations apply. For a given excitation radiation a phosphor is to be chosen which absorbs the energy of the said radiation, at high intensity, without the excitation radiation simultaneously causing stimulation or quenching. Should excitation radiation range in a broader spectrum than the absorption spectrum of a given phosphor, it is possible to simultaneously use a mixture of two or more phosphors each having an absorption spectrum which differs from one another so as to utilize all energy available.

In so far as the spectral distribution of stimulated emission is concerned it should be noted that among phosphors which can be charged or excited by ultraviolet radiation it is possible to choose a phosphor having its maximum stimulated emission at the maximum sensitivity for the human eye.

Alternatively, a phosphor can be chosen which shows its maximum stimulated emission at the spectral sensitivity of a light sensitive device. Moreover, by choosing a mixture of phosphors having various stimulated-emission spectra, a broader distribution of released energy can be produced.

To carry out the method according to the invention, phosphors are used which after initial preparation and firing, take the shape of blocks, termed "phosphor cakes". The size of the crystals ranges between 0.01 and 1 micron depending on the particular material. These phosphor cakes must be crushed and ground to be suspended in a dispersion medium. As the phosphor crystals can be damaged during the crushing or grinding process, the damages can be minimized by using various fillers e.g. MgO, which make the phosphor cakes brittle and easier to pulverize, or by having resort to suitable grinding methods such as by grinding with abrasive material in an organic liquid, or by ball milling, etc.

Although the phosphors lose much of their luminescence sensitivity during the grinding process to obtain a very fine powder, they can be regenerated after grinding by subsequent firing under suitable atmosphere, e.g. under dry nitrogen including less than $10^{-5}$ mm of oxygen and less than $10^{-1}$ mm of water vapor, or under other gases containing argon or hydrogen sulfide.

With appropriate grinding and suitable regeneration technology, the phosphor blocks or lumps can be reduced to 1 micron or smaller size.

To convey the phosphors from a charging zone to a zone where they release the energy stored in them, the phosphor particles of small dimensions are suspended in colloidal form.

Two obvious possibilities exist of forming a colloid in which the dispersion medium is a liquid or a gas, i.e. the dispersed phase is the phosphor crystals.

Under colloidal form we mean a dispersion system where the phosphor particles are suspended in a media, allowing them free flotation, homogeneous distribution, and the suspended particles can travel with the same speed as the suspending medium. However, the size of the particles is uneven, and in some cases the small particles can stick together forming aggregations, the larger particles show tendency to settle down. This can be avoided by occasional agitation.

Various considerations govern the choice of the dispersion medium, i.e. its optical behaviour as the medium must be chemically inactive towards the various components of the system; its density should not cause difficulties in pumping; its water content, as the medium must be non-aqueous, bearing in mind that most phosphors are hygroscopic and their quality deteriorates with moisture.

Optically, the liquid or gas must be transparent in the exciting, stimulating, stimulated emission spectrum of the phosphor.

A suspension of luminescent particles can be obtained by various known technologies, e.g. colloid milling, the use of ultrasonic vibrators, etc.

Examples about the materials which can be used and about the process relating to their preparation can be found in U.S. Patents 2,522,074 by Urbach filed on September 12, 1950; 2,527,365 by Leverenz filed on October 24, 1950; 2,979,467 by Seymour filed on April 11, 1961 and 2,447,322 by Fonda filed on August 17, 1948.

Further information can be found in "Preparation and characteristics of solid luminescent materials" (John Wiley 1948); "Luminescence of solids" by H. W. Leverenz (Dover 1950); and "Colloid chemistry" by S. Voyutsky (Mir Publishers 1978).

Hereinafter an example of one method of preparing circulating media with the suspension of luminescent particles is described. The starting phosphor is No. 2 from T—1. The composition of the phosphor:

| 100% SrS | Base |
| --- | --- |
| 9% $CaF_2$ | Flux 1 |
| 9% $SrSO_4$ | Flux 2 |
| 100 ppm Europium | Activator 1 |
| 100 ppm Samarium | Activator 2 |

The mixture is placed in a clean alumina crucible and heated up to 1000°C with 20°C/min. speed, held on 1000°C for 60 minutes, cooled down to room temperature with 5°C/min. speed, in an electrical tube furnace, in an atmosphere of dry nitrogen. The precise method of preparing this phosphor can be found in U.S. Patent 2,522,075 by Urbach.

The cooled phosphor cake is broken down to smaller chunks, then transferred to a mixer mill. The grinding container is made of alumina ceramic, including the two grinding balls. The phosphor is ground for a period of 15—20 minutes together with cedar oil, in 1:5 phosphor/oil proportion.

The ground mixture diluted with cedar oil to the concentration of 5 gr. phosphor to 100 gr. oil, is then transferred to a colloidal mill, which is a rotating 12 cm. diameter flask with three 2 cm. diameter porcelain balls.

The mill is rotating with such a low speed, that the balls are turning with the flask to about one quarter turn, then drop to the bottom of the container. This rotational process lasts 20—30 hours. In the resulting liquid the phosphor particles are microscopic size, and homogeneously distributed.

This colloid is transferred to a settling container, and is left there 24 hours. This time is sufficient for the bigger particles to settle down. These bigger particles are separated from the rest of the colloid and the process of milling and settling is repeated over and over again as long as the amount of settled particles is negligible. Finally the colloid is mixed with a high speed, propeller-type agitator.

The method of storing and conveying energy according to the present invention is further described below in detail with reference to the accompanying drawings, in which:

Figure 1 diagrammatically shows a first system for carrying out the method;

Figure 2 shows a modification of the system illustrated in Fig. 1 and comprises a storage unit for exhausted phosphors;

Figure 3 shows a third system having two storage units, one for charged phosphors and the other for exhausted phosphors;

Figure 4 shows a fourth system having two more complex storage units;

Figure 5 shows another modification of the system for carrying out the method in accordance with the invention, the system having one complex storage unit; and

Figure 6 is a diagram illustrating the stimulated-emission intensity as a function of time for a stationary phosphor.

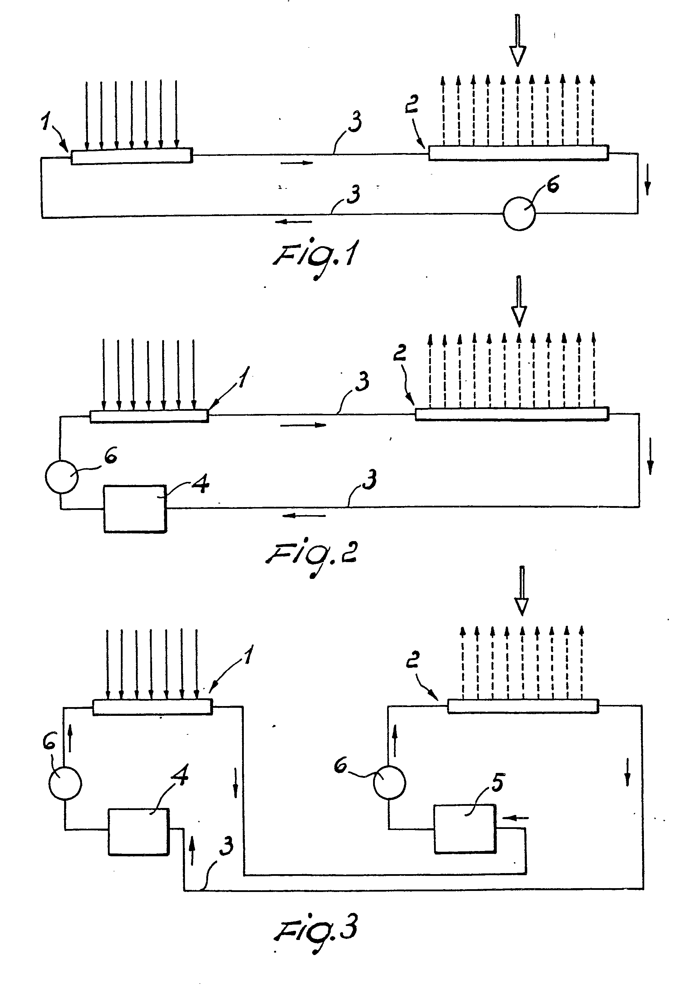

Figure 1 shows a system for absorbing, conveying and releasing light energy suitable for carrying out the method according to the invention.

The system comprises an energy absorption section generally indicated by the reference numeral 1 in the drawing, an energy releasing section 2, and a circuit 3 for transporting or conveying luminescent material. Moreover, a pump 6 is provided for circulating luminescent material through the various sections of the system.

The energy absorption section 1 is constructed in such a way that it fits the nature of the excitation radiation and a minimum of its surface area can receive a maximum amount of excitation radiation. In some cases, it might be necessary to focus the incident radiation onto the absorbing surface.

To obtain high efficiency in the system, stimulating or quenching wavelengths should be filtered off if present in the radiation generated by the excitation radiation source. For instance, the phosphors 1, 2, 3, 4 and 9 in Table 1 are adequately excited by blue light and with the CORNING® 4—97 and 4—69 filters can be used which allow 90% transmission at the maximum absorption of the phosphors. OREIL® 5786 filters allowing 80% transmission at 300 nm are suitable for the phosphors 5 and 7.

The infrared-blanking OREIL filters are quite useful for phosphors having a very wide absorption band.

In the case of a large absorption surface area, use can be made of various cheap plastics filters.

The section 1 is designed to convey partly or fully exhausted circulating medium to an excitation radiation exposure zone, and to keep it in that zone for a time sufficient to reach a fully or other desired charged state. A fully charged state is reached when no additional energy can be absorbed by the storage centers in the phosphors. The length of time required to reach such a state depends on the intensity and wavelength of the excitation radiation, the nature of the suspended luminescent particles and the excitation radiation penetration into the circulating medium.

Should the excitation radiation vary its intensity in time, its variations can be matched by adjusting the circulating medium flow-rate in the energy absorption section. the circulating medium flow can be uniform, continuously or periodically adjusted. In this way, energy absorption can be closely and flexibly controlled.

The cross-section of the circulation network must be such that the entire volume of circulating medium is homogeneously excited when leaving the energy absorption section. The network or circuit may be made of various highly transparent materials to exciting radiation. For instance, WF SPECTROSIL®, INFRASIL®, SILICA F® and other standard silica glasses can be used to obtain effective ultraviolet excitation of phosphors Nos. 5, 6, 7, 8, 10 and 11 in Table 1.

For ultraviolet excitation between 180 and 300 nm SUPRASIL® QUARTZ can be used as it transmits more than 80% of the energy in that wavelength range.

Optical glasses of inferior quality are suitable for phosphors having an absorption band in the visible light.

Another economic solution is the use of plastics although their chemical stability against the circulating medium should be taken into account (e.g. polystyrene transmits 80—85% of the visible light but cannot be used with oily suspension media).

The energy release section 2 is designed to convert the absorbed energy stored in it into stimulated emission. A continuously applied stimulation energy is needed for this section. Stimulation radiation is generally in the near infrared range although other types of radiation, e.g. thermal radiation, can be used in some cases.

In the case of infrared stimulation, various sources such as infrared emitting diodes (e.g. gallium-arsenic diodes produced by Texas Instruments Type 16A and Type 16B for the phosphor No. 1 in Table 1), infrared fluorescent phosphors, lamps with infrared filters (e.g. tungsten filament lamps with a CORNING 2540, POLAROID XR7X25 or KODAK n. 87C WRATTEN GELATIN filter)®, can be used.

The energy release process can be continuous or pulsed.

The circulating medium flow can be continuous, continuously or periodically varied.

The energy release rate depends on the stimulating radiation intensity and the flow-rate of the circulating medium. Thus, by altering these two parameters, the energy release can be adjusted according to requirements.

If for example two points A and B of the energy release section, respectively indicate the inlet of the charged medium and the outlet for the discharged medium, clearly stimulation takes place between A and B.

A number of cases should be considered.

1—If the medium is stationary and the stimulating radiation is uniform between A and B, the stimulated emission is uniform in the space but decreases in time according to a standard decay curve of a stationary colloid (Fig. 6).

2—If the medium circulates from A to B at constant flow-rate the circulation time is $t_1$, and

the stimulating radiation is uniform between A and B, the stimulated radiation decreases in the space and the stimulated emission intensity at A is that corresponding to the maximum in the exhaustion curve of a stationary medium, whereas at B it equals the intensity at the instant $t_1$ in the exhaustion curve.

3—The conditions being the same as those stated at point 2 above but with slower flow, stimulated emission decreases to a larger extent from A to B and the exhaustion level is higher.

4—The conditions being the same as those at point 2 above but at a faster flow, stimulated emission increases in the space between A and B but the exhaustion level at B is lower.

5—The conditions being the same as those at point 2 above but the stimulation radiation increasing from A to B, it is possible to approximate a constant stimulated-emission intensity with a good exhaustion level at B.

6—Moreover, variations can be provided in the spatial arrangement of the energy release section to regulate stimulated emission.

The energy release section 2 can be produced in various ways by using pipes, panels and ducts made of materials transparent in the stimulation and stimulated emission spectrum.

The conveying circuit 3 for the luminescent material is designed to convey the luminescent particles in suspension from one section of the system to another. Such a circuit must ensure protection against undesired stimulation and quenching of the medium while being placed in it.

The luminescent medium can be circulated through the circuit by means of a pump 6 or by gravity, etc.

Figure 2 shows a light energy absorption, transport and release system which is similar to that of Figure 1, except that it also comprises a storage unit 4 arranged downstream of the release section 2 to store exhausted medium.

Figure 3 shows another embodiment of a system for carrying out the method according to the invention, the system comprising an energy absorption section 1, a first store unit 5 for storing charged phosphors, an energy release section 2, a second storage unit 4 for exhausted phosphor, and a luminescent material conveying circuit 3. Moreover, the system includes two pumps 6 so that the sections 1 and 2 can operate independently of one another at different flowrates for the luminescent material.

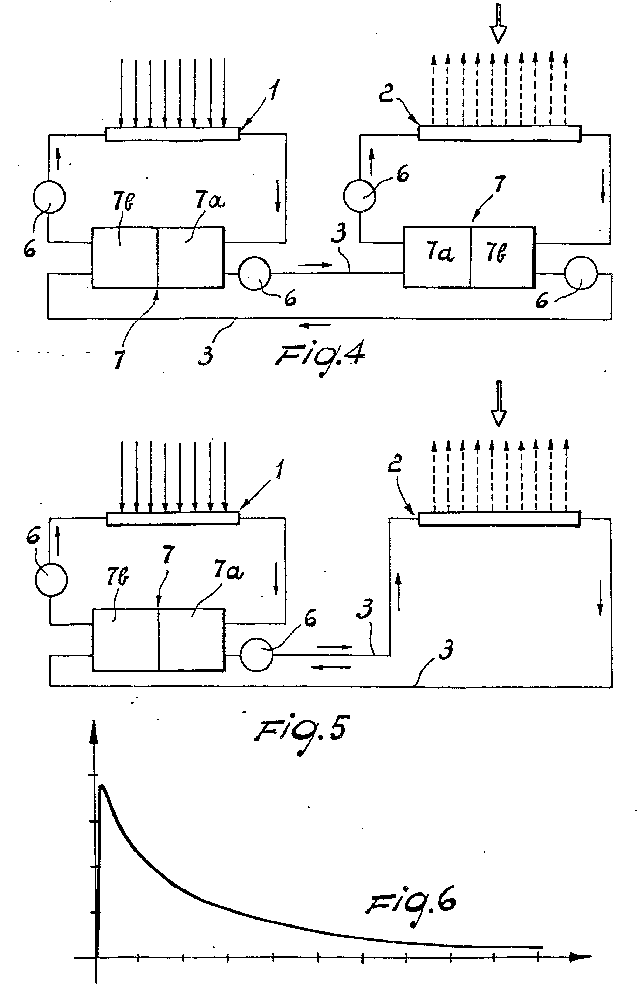

The system shown in Fig. 4 comprises an energy absorption section 1, a release section 2, a circuit 3 and four pumps 6, two more complex storage units 7 having a portion 7a for storing charged phosphors and a portion 7b for exhausted phosphors so that the storing, conveying and stimulation sections can operate independently of one another.

The system illustrated in Fig. 5 is similar to that of Fig. 4 except it has a single complex storage unit. In this case the storage unit 1 can operate independently of the remaining circuit, whereas the energy conveying and release sections are arranged in the same circuit.

The operation of the system for carrying out the method according to the present invention is clearly apparent from the preceding description. More particularly it should be noted that the circulation system has the function of absorbing light energy, storing the absorbed energy, conveying it and releasing it upon stimulation. The system can operate continuously or intermittently. The energy required for its operation is primarily that spent for circulating the medium and for stimulation.

In any case, the output energy (stimulated emission) is less than the input energy (excitation) plus the energy needed for the operation of the system. Thus, the efficiency for a given system also depends on the quality (quantum efficiency) of the luminescent material used and the characteristics of the system components.

The efficiency of the system doesn't hind the energy absorption storage, and release, but is only limiting the application range.

The method according to the invention is susceptible of numerous modifications and changes all of which fall within the scope of the present invention, and can be carried out by means of various systems other than those described above.

**Claims**

1. A method of storing and conveying electromagnetic energy, characterized by the steps of absorbing energy in the form of light, ultraviolet and alpha radiation, from a radiating energy source by means of luminescent material suspended in a dispersion fluid, conveying said luminescent material through an area exposed to the radiated energy and protected from stimulating and quenching radiation and releasing the stored or conveyed radiated energy from a charged luminescent fluid by conveying said luminescent material through an area exposed to stimulating radiation, wherein said stored energy is released under controlled conditions in the form of stimulated emission.

2. A method as claimed in Claim 1, wherein the energy absorption conditions and efficiency are controlled with a constant or variable exciting energy level by regulating the conveying velocity of the fluid luminescent material.

3. A method as claimed in Claim 1, wherein the energy releasing conditions and efficiency are controlled with a constant or variable stimulating intensity, by regulating the conveying velocity of the fluid luminescent material.

4. A system for absorbing, conveying, storing, reemitting radiated energy with continuous, intermittent, or periodical operation for carrying out the method of Claim 1, characterized in that it comprises an energy absorption section (7), a conveying circuit (3) and one or more storage units (4, 5, 7) for charged and discharged luminescent fluid protected against stimulation and quenching, and an energy releasing section (2) to discharge under controlled conditions the stored radiated energy from the luminescent material.

5. A system for absorbing, conveying, storing and reemitting radiated signals and information according to Claim 4, wherein said stimulating, quenching or exciting radiation and the conveyed and stored information can be recalled in form of detectable radiation, characterized in that it comprises a signal absorption section (1), a conveying circuit (3) and a signal releasing section (2) for the fluid luminescent material.

6. Fluid luminescent material for carrying the method of Claim 1, characterized in that it comprises luminescent particles of small size and a dispersion fluid, wherein said material has the ability of repeatedly absorbing, storing and releasing radiated energy.

**Patentansprüche**

1. Methode zum Speichern und Transportieren von elektromagnetischer Energie, dadurch gekennzeichnet, daß man Energie in Form von Licht-, Ultraviolett- und Alphastrahlung aus einer Strahlungsenergiequelle mit Hilfe von in einem Dispersionsfluid suspendiertem lumineszierendem Material absorbiert, das lumineszierende Material durch einen der Strahlungsenergie ausgesetzten und vor Erreger- und Löschstrahlung geschützten Bereich transportiert und die gespeicherte oder transportierte Strahlungsenergie aus einem geladenen lumineszierenden Fluid freisetzt, indem man das lumineszierende Material durch einen einer Erregerstrahlung ausgesetzten Bereich transportiert, wobei die gespeicherte Energie in Form einer induzierten Emission unter gesteuerten Bedingungen freigesetzt wird.

2. Methode nach Anspruch 1, dadurch gekennzeichnet, daß die Bedingungen und die Wirksamkeit der Energieabsorption mit einem konstanten oder variablen Erregerenergieniveau durch Regelung der Transportgeschwindigkeit des lumineszierenden Fluidmaterials gesteuert werden.

3. Methode nach Anspruch 1, dadurch gekennzeichnet, die Bedingungen und die Wirksamkeit der Energiefreisetzung mit einer konstanten oder variablen Erregerintensität durch Regelung der Transportgeschwindigkeit des Lumineszierenden Fluidmaterials gesteuert werden.

4. System für die Absorption, den Transport, die Speicherung und die Wiederfreisetzung von Strahlungsenergie in kontinuierlicher, intermittierender oder periodischer Verfahrensweise zur Durchführung der Methode nach Anspruch 1, gekennzeichnet durch einen Energieabsorptionsabschnitt (7), einen Transportkreis (3) und eine oder mehrere Speichereinheiten (4, 5, 7) für ein geladenes und entladenes lumineszierendes Fluid, welches gegen Erregung und Löschen geschützt ist, und einen Energiefreisetzungsabschnitt (2), um die gespeicherte Strahlungsenergie aus dem lumineszierenden Material unter kontrollierten Bedingungen zu entladen.

5. System für die Absorption, den Transport, die Speicherung und Wiederfreisetzung von Strahlungssignalen und -information nach Anspruch 4, wobei die Anregungs-, Lösch- oder Erregerstrahlung und die transportierte und gelagerte Information in Form einer nachweisbaren Strahlung abgerufen werden kann, gekennzeichnet durch einen Signalabsorptionsabschnitt (1), einen Transportkreis (3) und einen Signalfreisetzungsabschnitt (2) für das lumineszierende Fluidmaterial.

6. Lumineszierendes Fluidmaterial zur Durchführung der Methode nach Anspruch 1, dadurch gekennzeichnet, daß es aus lumineszierenden Teilchen von kleiner Teilchengröße und einem Dispersionsfluid besteht, wobei dieses Material zur wiederholten Absorption, Speicherung und Freisetzung von Strahlungsenergie befähigt ist.

**Revendications**

1. Procédé de stockage et de déplacement d'énergie électromagnétique caractérisé par les étapes consistant à absorber de l'énergie sous la forme de rayonnement lumineux, ultraviolet et alpha d'une source de rayonnement d'énergie au moyen d'un matériau luminescent en suspension dans un fluide de dispersion, à déplacer ledit matériau luminescent dans une zone exposée à l'énergie rayonnée et portégée d'un rayonnement de stimulation et d'extinction et à libérer l'énergie rayonnée stockée ou déplacée depuis un fluide chargé luminescent en déplaçant ledit matériau luminescent dans une zone exposée à un rayonnement de stimulation, ladite énergie emmagasinée étant libérée sous conditions ontrôlées sous la forme d'une émission stimulée.

2. Procédé selon la revendication 1, caractérisé par le fait que les conditions et le rendement d'absorption d'énergie sont contrôlés avec un niveau d'énergie d'excitation constant ou variable en réglant la vitesse de déplacement du matériau fluide luminescent.

3. Procédé selon la revendication 1, caractérisé par le fait que les conditions et le rendement de libération d'énergie sont contrôlés avec une intensité de stimulation constante ou variable en réglant la vitesse de déplacement du matériau fluide luminescent.

4. Système pour absorber, déplacer, stocker et réémettre de l'énergie rayonnée avec un fonctionnement continu, intermittent ou périodique pour mettre en oeuvre le procédé de la revendication 1, caractérisé par le fait qu'il comprend une partie (7) d'absorption d'énergie, un circuit de déplacement (3) et une ou plusieurs unités de stockage (4, 5, 7) pour charger et décharger un fluide luminescent protégé contre la stimulation et l'extinction et une partie (2) de libération d'énergie pour décharger sous conditions contrôlées l'énergie rayonnée stockée depuis le matériau luminescent.

5. Système pour absorber, déplacer, stocker et réémettre des signaux et de l'information rayonnée selon la revendication 4, caractérisé par le fait que ledit rayonnement de stimulation, d'extinction ou d'excitation et l'information déplacée et stockée peuvent être rappelés sous la forme d'un rayonnement détectable, caractérisé par le fait qu'il comprend une partie (1) d'absorption de signal, un circuit de déplacement (3) et une partie (2) de libération du signal pour le matériau fluide luminescent.

6. Matériau fluide luminescent pour mettre en oeuvre le procédé de la revendication 1, caractérisé par le fait qu'il comprend des particules luminescentes de petite dimension et un fluide de dispersion, ledit matériau ayant la possibilité d'absorber, d'emmagasiner et de libérer de façon répétée de l'énergie rayonnée.

Fig.1

Fig.2

Fig.3

1

Fig.4

Fig.5

Fig.6